(19) Europäisches Patentamt
European Patent Office
Office européen des brevets

(11) **EP 2 137 330 B1**

(12) **EUROPÄISCHE PATENTSCHRIFT**

(45) Veröffentlichungstag und Bekanntmachung des Hinweises auf die Patenterteilung:
**14.09.2011 Patentblatt 2011/37**

(21) Anmeldenummer: **08748744.3**

(22) Anmeldetag: **14.04.2008**

(51) Int Cl.:
**C22C 19/03** (2006.01)

(86) Internationale Anmeldenummer:
**PCT/DE2008/000615**

(87) Internationale Veröffentlichungsnummer:
**WO 2008/125091 (23.10.2008 Gazette 2008/43)**

(54) **METALLFOLIE**

METAL FOIL

FEUILLE MÉTALLIQUE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **17.04.2007 DE 102007018408**
**27.03.2008 DE 102008016222**

(43) Veröffentlichungstag der Anmeldung:
**30.12.2009 Patentblatt 2009/53**

(73) Patentinhaber:
• **ThyssenKrupp VDM GmbH**
**58791 Werdohl (DE)**
• **Zenergy Power GmbH**
**53359 Rheinbach (DE)**

(72) Erfinder:
• **HATTENDORF, Heike**
**58791 Werdohl (DE)**
• **GEHRMANN, Bodo**
**58840 Plettenberg (DE)**
• **BÄCKER, Michael**
**50670 Köln (DE)**
• **EICKEMEYER, Jörg**
**01279 Dresden (DE)**

(74) Vertreter: **Döpp, Ludger**
**Rechtsanwälte Spannagel & Döpp**
**Schulstrasse 52**
**58332 Schwelm (DE)**

(56) Entgegenhaltungen:
**DE-A1- 10 005 861     US-B1- 6 447 714**

• **SUBRAMANYA SARMA V ET AL: "Recrystallisation texture and magnetisation behaviour of some FCC Ni-W alloys" SCRIPTA MATERIALIA, ELSEVIER, AMSTERDAM, NL, Bd. 50, Nr. 7, 1. April 2004 (2004-04-01), Seiten 953-957, XP004488523 ISSN: 1359-6462**
• **EICKEMEYER J ET AL: "Highly cube textured Ni-W-RABiTS tapes for YBCO coated conductors" PHYSICA C, NORTH-HOLLAND PUBLISHING, AMSTERDAM, NL, Bd. 372-376, 1. August 2002 (2002-08-01), Seiten 814-817, XP004375541 ISSN: 0921-4534**

**Beschreibung**

Die Erfindung betrifft eine Metallfolie, im Wesentlichen bestehend aus Nickel und Wolfram.

Sehr reine Nickellegierungen sind während der Warmumformung (z.B. Block-Brammenwalzung) anfällig hinsichtlich Materialfehlern, wie Rissen und Brüchen, insbesondere in dem Fall, wenn ein gegossener Block (z.B. VIM) noch umgeschmolzen (z.B. VAR) wird.

Für besondere Einsatzfälle, wie z.B. supraleitende Bänder werden sehr reine Legierungen benötigt, so dass hier ein Zielkonflikt gegeben ist.

Die DE 100 05 861 C2 offenbart einen metallischen Werkstoff auf Nickelbasis und ein Verfahren zu dessen Herstellung. Der Werkstoff weist eine Rekristallisations-Würfeltextur auf und besteht aus einer Nickellegierung mit der Zusammensetzung $Ni_a (Mo_b, W_c)_d M_e$, worin M für ein oder mehrere Metalle mit Ausnahme von Ni, Mo. Fe oder W steht, mit

$$a = 100 - (d + e)$$

$$(d + e) \leq 50$$

$$b = 0 - 12$$

$$c = 0 - 12$$

$$d = (b + c) = 0{,}01 - 12$$

$$e = 0 - 49{,}9$$

jeweils in Atom-% und mit gegebenenfalls enthaltenen geringen herstellungstechnisch bedingten Verunreinigungen.

Zur Herstellung wird zunächst auf schmelzmetallurgischem oder pulvermetallurgischem Wege oder durch mechanisches Legieren eine Legierung der genannten Zusammensetzung erzeugt und diese mit einer Warmumformung sowie einer nachfolgenden hochgradigen Kaltumformung zu Band verarbeitet. Dieses wird in reduzierender oder nicht oxidierender Atmosphäre einer rekristallisierenden Glühung unterworfen. Derartige Legierungen werden heute im Wesentlichen nur im Labormaßstab, bzw. in kleinen Gebinden im kg-Bereich, erschmolzen, so dass ein hoher Reinheitsgrad herbeigeführt werden kann. Diese Maßgabe ist jedoch nicht zwangsläufig auf großtechnische Einsatzfälle im t-Bereich übertragbar. Im Gegenteil ist davon auszugehen, dass dieser Werkstoff als Block von mehreren hundert Millimetern Durchmesser während der Warmformgebung bricht und die Ausbringung an Gutmaterial damit unter die ökonomisch vertretbare Grenze für ein kommerzielles Produkt sinkt.

In der DE 10 2004 041 053 B4 wird eine dicke REBCO-Schicht für Coated Conductors beschrieben, wobei die Schicht über Chemical Solution Deposition (CSD) erzeugt wird und ein Hochtemperatur-Supraleiter-Bandleiter zumindest ein Trägermaterial, eine Pufferschicht und einen Hochtemperatur-Supraleiter beinhaltet. Dieses Patent befasst sich mit dem Aufbringen der Puffer- und Supraleiterschichten auf dem Trägersubstrat, geht aber nicht auf die Besonderheiten des Substrates selbst ein.

Durch die DE 102 00 445 B4 ist ein Metallband für epitaktische Beschichtungen und ein Verfahren zur Herstellung desselben bekannt geworden. Das Metallband besteht aus einem Schichtverbund aus mindestens einer biaxial texturierten Basisschicht der Metalle Ni, Cu, Ag oder deren Legierungen und mindestens einer weiteren metallischen Schicht, wobei die einzelnen weiteren metallischen Schichten aus einer oder mehreren intermetallischen Phasen oder aus einem Metall bestehen, in dem eine oder mehrere intermetallische Phasen enthalten sind. Das System Nickel-Wolfram bleibt unerwähnt, ebenso die Herausforderungen, die sich in der industriellen Fertigung, insbesondere bei der Warmformgebung, stellen.

Der Erfindung liegt die Aufgabe zugrunde, eine im Wesentlichen aus Nickel und Wolfram bestehende Metallfolie dergestalt durch Zugabe definierter Legierungselemente zu optimieren, dass ein hoher Grad an wirtschaftlicher Fertigung im Rahmen großtechnischer Einsatzfälle mit geringem Ausschuss gegeben ist und gleichzeitig die Anforderungen für die Weiterverarbeitung zum Hochtemperatur-Supraleiter-Schichtverbund erfüllt werden.

Diese Aufgabe wird gelöst durch eine Metallfolie nach Anspruch 1.

Bevorzugte Gehalte an Ni und W sind (in Gew.-%)

| | |
|---|---|
| Ni | 83-88% |
| W | 12-17% |

Zur Erhöhung der Reinheit dieser Legierung können die Gehalte an Ni und W noch weiter eingeschränkt werden, nämlich (in Gew.-%)

| | |
|---|---|
| Ni | 85-87% |
| W | 13-15%. |

Die erfindungsgemäße Metallfolie ist zur weiteren Erhöhung der Reinheit, respektive zur besseren Verarbeitung der Legierung vorteilhafterweise mit Gehalten an Al und/oder Mg und/oder B (in Gew.-%) wie folgt versehen

| | |
|---|---|
| Al | 0,0001 - 0,0006 % |
| Mg | 0,0001 - 0,015 % |
| B | 0,0001 - 0,002 % |

An Begleitelementen (herstellungsbedingte Verunreinigungen) werden folgende Elemente mit zugehörigen Gehalten (in Gew.-%) angesehen:

| | |
|---|---|
| Cr | max. 0,05 % |
| Fe | <0.1% |
| Co | max. 0,05 % |
| C | max. 0.04% |
| Cu | <0,05 % |
| Mn | <0,05 % |
| Mo | max. 0,05 % |
| Nb | max. 0,01 % |
| P | <0,004 % |
| O | <0,005 % |
| S | <0,004 % |
| Si | max. 0,05 % |
| N | <0,005 % |
| Ti | <0,01%. |

Um die gewünschte Reinheit der Legierung, insbesondere bei der großtechnischen Erschmelzung > 1 t, insbesondere > 3 t, herbeiführen zu können, sollen die vorab genannten Begleitelemente möglichst unterhalb der genannten Angaben eingestellt werden.

Folgende Grenzwerte der an sich unerwünschten Begleitelemente erscheinen für großtechnische Anwendungsfälle aus heutiger Sicht unter kommerziellen Gesichtspunkten im Rahmen vertretbarer Kosten realisierbar zu sein (in Gew.-%):

| | |
|---|---|
| Cr | <0,01 % |
| Fe | <0,05 % |
| Co | <0,05 % |
| C | <0,01 % |
| Cu | <0,03 % |
| Mn | <0,03 % |
| Mo | <0,03 % |

(fortgesetzt)

| | |
|---|---|
| Nb | <0,005 % |
| P | <0,003 % |
| O | <0,004 % |
| S | <0,0008 % |
| Si | <0,04 % |
| N | <0,004 % |
| Ti | <0,01 %. |

Die erfindungsgemäße Metallfolie kommt in Analogie zur DE 102 00 445 B4 bevorzugt als Metallband für epitaktische Beschichtungen zum Einsatz.

Das durch VIM und bedarfsweise VAR erzeugte Ausgangsmaterial wird warm verformt, durch einen hohen Kaltumformungsgrad (> 90 %) in einem speziellen Fertigungsprozess bearbeitet und anschließend im Temperaturbereich zwischen 700°C und 1.200°C geglüht. Hierbei bildet sich ein großer Anteil an Würfeltextur aus. Um eine hohe Güte hinsichtlich Würfeltexturanteil zu erreichen, muss die Reinheit der Legierung sehr hoch sein, das heißt, der Gehalt der angesprochenen Begleitelemente, die die Ausbildung der Würfeltextur behindern, muss sehr klein sein. Besonders hervorzuheben ist, dass, abweichend vom Stand der Technik gemäß DE 100 05 861 C2, nun auch großtechnische Einsätze in Gewichtsbereichen > 3 t möglich sind, ohne dass der geforderte Anspruch an die Reinheit der erfindungsgemäßen Legierung in Frage gestellt werden muß.

Dem eingangs aufgezeigten Zielkonflikt wird nun durch konkrete Zulegierung der Elemente Mg und/oder B und/oder Al entgegengewirkt, da diese Elemente eine gute bzw. verbesserte Warmumformbarkeit des großtechnisch erzeugten Ausgangsmaterials begünstigen und im Fall der beschriebenen Zugaben den Anforderungen hinsichtlich der Ausprägung der Würfeltextur genügen, ohne dass dadurch die Weiterverarbeitung der Metallfolie eingeschränkt wird.

Einem weiteren Gedanken der Erfindung gemäß wird eine Metallfolie vorgeschlagen, deren Oberfläche einen statischen Kontaktwinkel < 80° aufweist, der mit einem Gemisch aus deionisiertem Wasser und Propionsäure im Wesentlichen im Verhältnis 1 : 1 gemessen wird.

Für bestimmte Einsatzfälle kann es sinnvoll sein, einen statischen Kontaktwinkel < 75°, bzw. < 70°, vorzusehen.

Tabelle 1 zeigt chemische Zusammensetzungen dreier erfindungsgemäßer Laborchargen sowie einer erfindungsgemäßen großtechnisch erzeugten Charge > 3 t (in Gew.-%):

| Chargen-Nr. | LB 2000 | LB 2002 | LB 2004 | GT 171325 |
|---|---|---|---|---|
| Element | Gew.-% | Gew.-% | Gew.-% | Gew.-% |
| Al | <0,001 | <0,001 | 0,006 | 0,005 |
| B | <0,001 | <0,001 | 0,001 | 0,001 |
| Mg | <0,001 | 0,013 | 0,01 | 0,003 |
| Ni | 86,727 | 86,001 | 85,747 | 85,55 |
| W | 13,25 | 13,94 | 14,09 | 14,3 |
| Cr | 0,006 | 0,008 | 0,024 | 0,01 |
| Fe | <0,005 | <0,005 | 0,07 | 0,05 |
| Co | 0,005 | 0,006 | 0,007 | 0,01 |
| C | 0,002 | 0,003 | <0,003 | 0,004 |
| Cu | <0,001 | <0,006 | 0,002 | 0,01 |
| Mn | <0,001 | <0,001 | 0,001 | 0,01 |
| Mo | 0,004 | 0,005 | 0,012 | 0,01 |
| Nb | 0,001 | 0,001 | 0,001 | 0,001 |
| P | <0,002 | <0,002 | 0,002 | 0,002 |
| O | <0,002 | 0,004 | 0,004 | 0,003 |
| S | <0,001 | <0,001 | <0,002 | 0,0005 |

(fortgesetzt)

| Chargen-Nr. | LB 2000 | LB 2002 | LB 2004 | GT 171325 |
|---|---|---|---|---|
| Element | Gew.-% | Gew.-% | Gew.-% | Gew.-% |
| Si | <0,001 | 0,014 | 0,017 | 0,02 |
| N | <0,001 | <0,001 | <0,004 | 0,002 |
| Ta | 0,005 | 0,005 | 0,005 | |
| Ti | <0,001 | <0,001 | <0,001 | 0,01 |

Abweichend von den Laborchargen LB 2000, LB 2002 und LB 2004 wurde die Charge GT 171325 mit einem Schmelzvolumen von 5 t erzeugt. Die großtechnisch erzeugte Legierung GT 171325 wurde im VIM-Verfahren erschmolzen. Der Vergleich zwischen den Laborchargen und der großtechnisch erzeugten Charge zeigt, dass die großtechnisch erzeugte Charge hinsichtlich ihres Reinheitsgrades den labormäßigen Chargen nicht nachsteht und somit eine wirtschaftliche Fertigung bei minimierten Ausfällen der späteren Produkte gegeben ist.

Das VIM-Ausgangsmaterial konnte problemlos von Block an Bramme und weiter an Warmband warm gewalzt werden. Dabei traten keine Brüche auf. Das Band wurde durch einen hohen Kaltumformungsgrad (> 90 %) in einem speziellen Fertigungsprozess bearbeitet und danach im Temperaturbereich zwischen 850 und 1150°C geglüht. Hinsichtlich des hohen Reinheitsgrades der großtechnisch so erzeugten Charge, bedingt durch die kontrollierte Zugabe an Al und/oder Mg und/oder B in den erfindungsgemäßen Gehalten, konnte eine hohe Güte an Würfeltexturanteil erreicht werden.

Im Folgenden wird das Verfahren zur Messung des statischen Kontaktwinkels näher beschrieben:

Dieses Verfahren ermöglicht die Charakterisierung der Oberflächeneigenschaften von Festkörpern. Für die Ermittlung der Eigenschaften des Ni-W-Bandes eignet sich Wasser oder ein Gemisch aus Wasser / Propionsäure im Verhältnis 1:1. Das verwendete Wasser wurde über Ionentauscher gereinigt und sollte eine Restleitfähigkeit unter 5,0 $\mu Scm^{-1}$ haben. Die Propionsäure besitzt eine Reinheit von 99,5 % und eine Dichte zwischen 0,993 und 0,995 $gcm^{-3}$. Sie wurde keiner speziellen Nachbehandlung unterzogen.

Die Messung erfolgt an einem Axiotech Auflichtmikroskop unter Verwendung eines Epiplan 5x/0,13 HD Objektivs. Da eine Messung von oben nicht möglich ist, wird der Strahlengang des Mikroskops über einen Spiegel um 90° umgelenkt, so dass das Bild von der Seite aufgenommen wird.

Die Oberfläche der Probe muss möglichst plan sein, so dass sie vorzugsweise mit einem Seitenschneider statt einer Schere zugeschnitten wird, falls dies erforderlich ist. Das Band wird möglichst bis kurz vor der Messung unter trockenem Schutzgas (99,99proz. Stickstoff) aufbewahrt, um eine Verfälschung der Messergebnisse durch Oberflächenoxidation zu verhindern. Zusätzlich wird das Band 15 min im Ultraschallbad mit *i*-Propanol gereinigt und bei 80 °C im Vakuum getrocknet.

Die Probe wird mit doppelseitigem Klebeband auf einem Objektträger fixiert und unter Vermeidung von Dellen leicht angepresst. Die benötigte Flüssigkeit wird unter Verwendung einer Spritze mit Kanüle aufgetragen, das aufgebrachte Volumen sollte immer gleich groß sein. Die Messung erfolgt bei 22 °C.

Die Auswertung der Messung erfolgt mit Hilfe eines geeigneten Grafikprogramms. Der Kontaktwinkel $\Theta$ ergibt sich aus der Höhe h des Tropfens und der Breite *I* über den Zusammenhang

$$\tan\left(\frac{\Theta}{2}\right) = 2\frac{h}{I}$$

Eine ausreichende Benetzung mit Beschichtungslösungen wird erreicht, wenn der Kontaktwinkel des Bandes mit deionisiertes Wasser nicht größer ist als 80°, eine außerordentlich gute Benetzung wird erzielt, wenn der Kontaktwinkel gegen Wasser kleiner als 60° ist. Ist der Kontaktwinkel groß und liegt er insbesondere über 90 °, so ist es nicht möglich, nach der Benetzung eine texturierte Schicht auf dem Ni-W-Substrat aufzubringen.

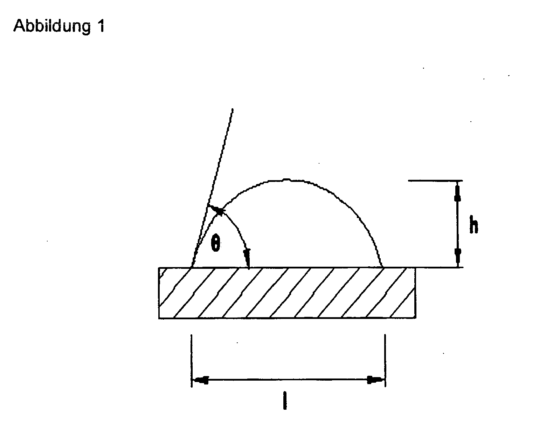

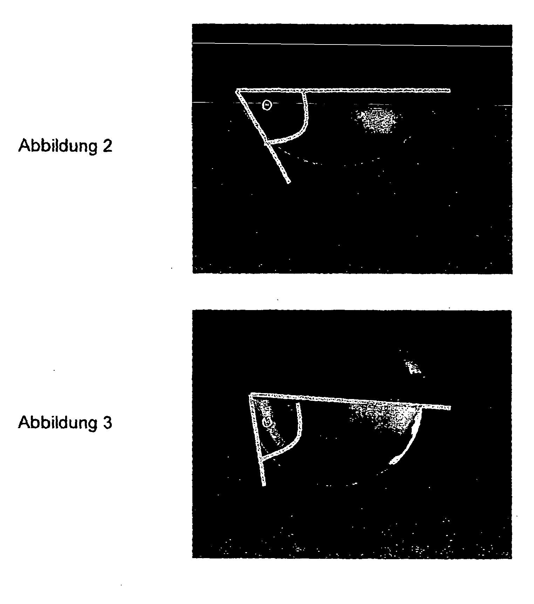

Der Erfindungsgegenstand ist in den Abbildungen 1 bis 3 dargestellt. Die Abbildungen zeigen:

Abbildung 1     Ermittlung des Kontaktwinkels $\Theta$

Abbildung 2    Kontaktwinkel < 75°. Das Substrat wird bei der Beschichtung mit Precursorlösung gut beschichtet.

Abbildung 3    Kontaktwinkel > 80°. Eine Beschichtung mit Precursorlösung führt zu mangelhaften Resultaten

**Patentansprüche**

1.  Metallfolie mit (in Gew.-%)

|     |          |
| --- | -------- |
| Ni  | 80-90%.  |
| W   | 10-20 %  |

sowie Al und/oder Mg und/oder B in Gehalten

|     |                      |
| --- | -------------------- |
| Al  | 0,0001 - max. 0,02 % |
| Mg  | 0,0001 - max. 0,015 %|
| B   | 0,0001 - max. 0,005 %.|

2.  Metallfolie nach Anspruch 1, mit Gehalten (in Gew.-%)

|     |        |
| --- | ------ |
| Ni  | 83-88% |
| W   | 12-17% |

3.  Metallfolie nach Anspruch 1 oder 2, mit Gehalten (in Gew.-%)

|     |        |
| --- | ------ |
| Ni  | 85-87% |
| W   | 13-15% |

4.  Metallfolie nach einem der Ansprüche 1 bis 3, mit Gehalten an Al und/oder B (in Gew.-%)

|     |                  |
| --- | ---------------- |
| Al  | 0,0001 - 0,006 % |
| B   | 0,0001 - 0,002 %.|

5.  Metallfolie nach einem der Ansprüche 1 bis 4, **dadurch gekennzeichnet, dass** die Begleitelemente (in Gew.-%) wie folgt in der Legierung eingestellt sind:

|     |            |
| --- | ---------- |
| Cr  | max. 0,05 %|
| Fe  | <0,1%      |
| Co  | max. 0,05 %|
| C   | max. 0,04 %|
| Cu  | <0,05%     |
| Mn  | <0,05%     |
| Mo  | max. 0,05 %|
| Nb  | max. 0,01 %|
| P   | <0,004 %   |
| O   | <0,005 %   |
| S   | <0,004 %   |
| Si  | max. 0,05 %|

(fortgesetzt)

| | |
|---|---|
| N | <0,005% |
| Ti | <0,01 %. |

6. Metallfolie nach einem der Ansprüche 1 bis 5, **dadurch gekennzeichnet, dass** die Begleitelemente (in Gew.-%) wie folgt in der Legierung eingestellt sind:

| | |
|---|---|
| Cr | <0,01 % |
| Fe | <0,05 % |
| Co | <0,05 % |
| C | <0,01 % |
| Cu | <0,03 % |
| Mn | <0,03 % |
| Mo | <0,03 % |
| Nb | <0,005 % |
| P | <0,003 % |
| O | <0,004 % |
| S | <0,0008 % |
| Si | <0,04 % |
| N | <0,004 % |
| Ti | <0,01 %. |

7. Metallfolie nach einem der Ansprüche 1 bis 6, die durch einen Kaltumformgrad > 90 % eines Ausgangsmaterials mit anschließender Glühbehandlung im Temperaturbereich zwischen 700 und 1.200°C erzeugt ist.

8. Metallfolie nach einem der Ansprüche 1 bis 7, wobei die Oberfläche der Folie einen statischen Kontaktwinkel < 80° aufweist, der mit einem Gemisch aus deionisiertem Wasser und Propionsäure im Verhältnis 1:1 gemessen wird.

9. Metallfolie nach einem der Ansprüche 1 bis 8, wobei die Oberfläche der Folie einen statischen Kontaktwinkel < 75° aufweist, der mit einem Gemisch aus deionisiertem Wasser und Propionsäure im Verhältnis 1:1 gemessen wird.

10. Metallfolie nach einem der Ansprüche 1 bis 9, wobei die Oberfläche der Folie einen statischen Kontaktwinkel < 70° aufweist, der mit einem Gemisch aus deionisiertem Wasser und Propionsäure im Verhältnis 1:1 gemessen wird.

11. Metallfolie nach einem der Ansprüche 1 bis 10, welche in Schmelzmengen über eine Tonne erzeugt wird.

12. Verwendung einer Metallfolie nach einem der Ansprüche 1 bis 10 als Metallband für epitaktische Beschichtungen.

**Claims**

1. A metal foil comprising (in % by mass)

| | |
|---|---|
| Ni | 80 - 90 % |
| W | 10 - 20 % |

as well as Al and/or Mg and/or B having contents of

| | |
|---|---|
| Al | 0.0001 - max. 0.02 % |
| Mg | 0.0001 - max. 0.015 % |
| B | 0.0001 - max. 0.005 %. |

2. A metal foil according to claim 1 comprising contents of (in % by mass)

| | |
|---|---|
| Ni | 83-88 % |
| W | 12-17 %. |

3. A metal foil according to claim 1 or 2 comprising contents of (in % by mass)

| | |
|---|---|
| Ni | 85-87 % |
| W | 13-15 %. |

4. A metal foil according to one of the claims 1 through 3 comprising contents of Al and/or B (in % by mass)

| | |
|---|---|
| Al | 0.0001 - 0.006 % |
| B | 0.0001 - 0.002 %. |

5. A metal foil according to one of the claims 1 through 4, **characterized in that** the companion elements (in % by mass) are set in the alloy as follows:

| | |
|---|---|
| Cr | max. 0.05 % |
| Fe | <0.1% |
| Co | max. 0.05 % |
| C | max. 0.04 % |
| Cu | <0.05 % |
| Mn | <0.05 % |
| Mo | max. 0.05 % |
| Nb | max. 0.01 % |
| P | <0.004 % |
| O | < 0.005 % |
| S | < 0.004 % |
| Si | max. 0.05 % |
| N | < 0.005 % |
| Ti | <0.01 %. |

6. A metal foil according to one of the claims 1 through 5, **characterized in that** the companion elements (in % by mass) are set in the alloy as follows:

| | |
|---|---|
| Cr | <0.01 % |
| Fe | <0.05 % |
| Co | < 0.05 % |
| C | <0.01 % |
| Cu | <0.03 % |
| Mn | < 0.03 % |
| Mo | < 0.03 % |
| Nb | < 0.005 % |
| P | < 0.003 % |
| O | < 0.004 % |
| S | < 0.0008 % |
| Si | <0.04 % |

(continued)

| | |
|---|---|
| N | < 0.004 % |
| Ti | <0.01 %. |

**7.** A metal foil according to one of the claims 1 through 6 which has been manufactured by a cold reduction of > 90 % of a base material followed by an annealing treatment in the temperature range comprised between 700 and 1200°C.

**8.** A metal foil according to one of the claims 1 through 7, wherein the surface of the foil comprises a static contact angle of < 80° which is measured with a mix of de-ionized water and propionic acid in the ratio of 1 : 1.

**9.** A metal foil according to one of the claims 1 through 8, wherein the surface of the foil comprises a static contact angle of < 75° which is measured with a mix of de-ionized water and propionic acid in the ratio of 1 : 1.

**10.** A metal foil according to one of the claims 1 through 9, wherein the surface of the foil comprises a static contact angle of < 70° which is measured with a mix of de-ionized water and propionic acid in the ratio of 1 : 1.

**11.** A metal foil according to one of the claims 1 through 10 which is manufactured in fusion quantities of more than one metric ton.

**12.** A use of a metal foil according to one of the claims 1 through 10 as metal strip for epitaxid coatings.

**Revendications**

**1.** Feuille métallique comprenant (en % en poids)

| | |
|---|---|
| Ni | 80-90% |
| W | 10-20% |

ainsi que des teneurs en Al et/ou Mg et/ou B comme suivant :

| | |
|---|---|
| Al | 0,0001-max. 0,02 % |
| Mg | 0,0001-max. 0,015 % |
| B | 0,0001-max. 0,005 %. |

**2.** Feuille métallique selon la revendication 1, comprenant des teneurs en (en % en poids)

| | |
|---|---|
| Ni | 83-88% |
| W | 12-17%. |

**3.** Feuille métallique selon la revendication 1 ou 2, comprenant des teneurs en (en % en poids)

| | |
|---|---|
| Ni | 85-87% |
| W | 13-15%. |

**4.** Feuille métallique selon l'une des revendications 1 à 3, comprenant des teneurs en Al et/ou en B (en % en poids) :

| | |
|---|---|
| Al | 0,0001-0,006 % |
| B | 0,0001-0,002 %. |

**5.** Feuille métallique selon l'une des revendications 1 à 4, **caractérisé en ce que** les éléments d'accompagnement (en % en poids) sont réglés dans l'alliage comme suivant :

| | |
|---|---|
| Cr | max. 0,05 % |
| Fe | <0,1 % |
| Co | max. 0,05 % |
| C | max. 0,04 % |
| Cu | <0,05 % |
| Mn | < 0,05 % |
| Mo | max. 0,05 % |
| Nb | max. 0,01 % |
| P | < 0,004 % |
| O | < 0,005 % |
| S | < 0,004 % |
| Si | max. 0,05 % |
| N | < 0,005 % |
| Ti | < 0,01 %. |

**6.** Feuille métallique selon l'une des revendications 1 à 5, **caractérisé en ce que** les éléments d'accompagnement (en % en poids) sont réglés dans l'alliage comme suivant :

| | |
|---|---|
| Cr | < 0,01 % |
| Fe | < 0,05 % |
| Co | < 0,05 % |
| C | < 0,01 % |
| Cu | < 0,03 % |
| Mn | < 0,03 % |
| Mo | < 0,03 % |
| Nb | < 0,005 % |
| P | < 0,003 % |
| O | < 0,004 % |
| S | < 0,0008 % |
| Si | < 0,04 % |
| N | < 0,004 % |
| Ti | < 0,01 %. |

**7.** Feuille métallique selon l'une des revendications 1 à 6 qui est fabriquée par un taux de déformation à froid de > 90 % d'une matière de base suivi d'un traitement de recuit dans un écart de températures compris entre 700 et 1200°C.

**8.** Feuille métallique selon l'une des revendications 1 à 7, dans laquelle la surface due la feuille comprend un angle de contact statique de < 80° qu'on mesure à l'aide d'un mélange composé d'eau désionisée et d'acide propionique présentes dans le rapport de 1:1.

**9.** Feuille métallique selon l'une des revendications 1 à 8, dans laquelle la surface de la feuille comprend un angle de contact statique de < 75° qu'on mesure à l'aide d'un mélange composé d'eau désionisée et d'acide propionique présentes dans le rapport de 1:1.

**10.** Feuille métallique selon l'une des revendications 1 à 9, dans laquelle la surface de la feuille comprend un angle de contact statique de < 70° qu'on mesure à l'aide d'un mélange composé d'eau désionisée et d'acide propionique présentes dans le rapport de 1:1.

**11.** Feuille métallique selon l'une des revendications 1 à 10 qu'on fabrique dans des quantités de fusion de plus d'une tonne métrique.

12. Utilisation d'une feuille métallique selon l'une des revendications 1 à 10 en tant que ruban métallique pour des revêtements épitaxiaux.

Abbildung 1

Abbildung 2

Abbildung 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10005861 C2
- DE 102004041053 B4
- DE 10200445 B4